# EUROPEAN PATENT APPLICATION

(11) **EP 4 746 621 A1**
(43) Date of publication of application: **20.05.2026**
(21) Application number: 24838416.6
(22) Date of filing: 10.05.2024
(51) Int. Cl.: H10B 41/40

(54) **MICROCONTROLLER CHIP**

(30) Priority: 10.07.2023 CN 202310841740
(71) Applicant: GigaDevice Semiconductor Inc., Haidian, Beijing 100094 (CN)
(72) Inventor: LI, Baokui, Beijing 100094 (CN); WANG, Qian, Beijing 100094 (CN); LI, Yuanyuan, Beijing 100094 (CN)
(74) Representative: dompatent
(86) International application number: PCT/CN2024/092130
(87) International publication number: WO 2025/011157

(57) **Abstract**

The present invention provides an MCU chip including an MCU die and at least one Flash die, which are packaged within a single package using an advanced packaging technique. The MCU die is provided with additional first pads, and the Flash die is provided with second pads corresponding to the first pads. A number of first interconnect lines connect the first and second pads, thereby forming multi-bit address lines, multi-bit data lines and multi-bit memory control lines between the MCU die and the Flash die, which enable parallel transmission of address signals, data signals and read, write and erase control signals between the MCU die and the Flash die. Compared with conventional MCU chips employing SiP flash memory, this is advantageous in fast data read and write speeds and comparable data read and write performance to eFlash memory.

## Description

### TECHNICAL FIELD

The present invention relates to the field of integrated circuit (IC) chips, and particularly to a microcontroller unit (MCU) chip.

### BACKGROUND

Microcontroller units (MCUs) are lightweight computing chips employed in many electronic devices as control cores because of low power consumption and the nature of allowing flexible programming. MCUs require associated memory for storing code and data generated during use of the MCUs.

Flash memory is an indispensable component of an MCU chip because of its role in storing code and data produced during MCU use. Embedded flash (eFlash) memory typically has its circuit integrated with a standard MCU circuit within a single MCU die. The disadvantage of eFlash memory of most concern is that Flash memory circuit must be fabricated using the same process as an associated standard MCU circuit. As MCU chips always develop towards higher technical nodes, eFlash memory imposes additional requirements on wafer foundries' technical reserves - at a given circuit area, the cost of fabricating an eFlash memory circuit is usually 30% higher than that of a standard circuit fabricated using the same process, and the 28/22 nm nodes of silicon photolithography technology are considered the last cost-effective nodes for eFlash memory. Therefore, it becomes the main obstacle for further advancement of the state-of-the-art MCU technology.

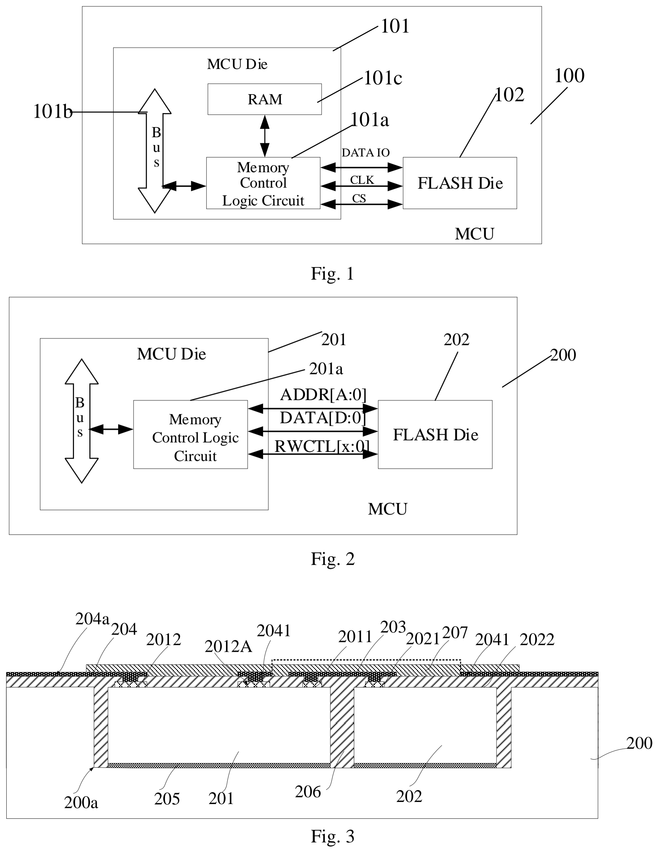

One available solution to the above problem is the use of the so-called system-in-a-package (SiP) flash memory. Specifically, referring to Fig. 1, in this solution, a logic circuit necessary for an MCU chip 100, such as a memory control logic circuit 101a (also known as a memory control module), a bus 101b and random-access memory 101c are integrated within a single MCU die 101, which is then packaged with a Flash die 102 using SiP packaging, resulting in an MCU chip in the form of a co-packaged chip 100. In this design, code and data for the MCU are stored in the Flash die 102 that is standalone and external to the MCU die 101, and the Flash die 102 and the MCU die 101 communicate with each other via a serial peripheral interface (SPI). When a read access request is received over the bus 101b, desired data is copied from the Flash die 102 to the random-access memory 101c under the control of the memory control logic circuit 101a and then read by the MCU die 101 from the random-access memory 101c. In response to a write access request being received over the bus 101b, the memory control logic circuit 101a writes the intended data to both the random-access memory 101c and the Flash die 102. This solution provides advantages including high capacity, inexpensive memory and a short time to market, and is not faced with many challenges in terms of fabrication. However, since the SPI interface is used between the SiP-packaged Flash die 102 and MCU die 101, data must be written and read byte-by-byte to and from the flash memory even if the interface has 8 I/O data lines (e.g., an OSPI interface), leading to slow code/data read and write speeds. Additionally, this solution requires configuring a match random-access memory 101c, which may lead to an area expansion of the MCU die 101.

### SUMMARY OF THE INVENTION

It is an object of the present invention to provide an MCU chip, which can be more flexibly configured and allows significantly faster data read and write speeds.

To this end, the present invention provides an MCU chip comprising:
an MCU die incorporating an internal memory control logic circuit and provided on its first side with a number of external first pads;
at least one Flash die incorporating an internal memory array and provided on its second side with a number of external second pads; and
a number of first interconnect lines connecting the second pads to corresponding first pads, thereby forming multi-bit address lines, multi-bit data lines and multi-bit memory control signal lines,
wherein the MCU die, the at least one Flash die and the number of first interconnect lines are packaged within a single package using an advanced packaging technique.

With this arrangement, address signals, data signals and read, write and erase control signals can be directly transmitted in parallel in a peer-to-peer manner without protocol conversion between the MCU die and the Flash die, providing higher data program, read and write speeds than SiP flash memory used in conventional MCUs. Moreover, data read and write performance between the MCU die and the externally connected Flash die is comparable to that of eFlash memory (i.e., a flash memory circuit integrated within a single die together with a memory control logic circuit of an MCU and the like), without needing a flash memory circuit being incorporated in the MCU die. Therefore, chip area savings and simpler manufacturing can be achieved, compared with the eFlash memory scheme.

Further, for a conventional MCU chip employing eFlash memory, when it is required to modify the size of the flash memory circuit, tape-out of various MCU die versions would be necessary for the MCU chip manufacturer. Usually, such versions would all reserve an area corresponding to maximum capacity required by the eFlash memory circuit in order to avoid altering the layout and/or wiring of the rest of the standard MCU circuit, leading to a waste of chip area. On the contrary, according to an embodiment of the present invention, when it is required to modify the flash memory capacity of the MCU chip, the Flash die can be simply replaced, without subjecting the MCU die to additional tape-out. This can reduce the time required for the development of the MCU chip and circumvent the need for reserving an area required by maximum eFlash memory capacity, allowing the MCU chip to have a reduced overall area.

Optionally, the MCU die and the Flash die may be arranged side by side, wherein the first pads are arranged on the first side of the MCU die proximal to the Flash die, and the second pads are arranged on the second side of the Flash die proximal to the MCU die. Arranging the first and second pads in proximity to each other makes the first interconnect lines easy to design and allows them to have a shorter length, improving line stability and accelerating data transmission.

Optionally, top surfaces of the MCU die and the Flash die may provide a fan-out surface of an intermediate package in the package. This scalable fan-out design dispenses with need for a lead frame, packaging substrate and the like and enables die packaging to be completed simply using an advanced packaging technique. Additionally, the resulting chip package has a comparable shape, smaller dimensions and better performance, for example, in terms of thermal simulation.

Optionally, the package may further comprise an internal redistribution layer formed on the fan-out surface, wherein a first portion of the redistribution layer serves as the first interconnect lines. With this arrangement, the first and second pads can be reliably connected within the MCU chip by redistribution wires without using solder joints. Additionally, the redistribution process is helpful in layout optimization of the first and second pads and can reduce wire crossovers within the package, or even completely eliminate the risk of wire crossing in extreme cases.

Optionally, at least one of the MCU die and the Flash die may be further provided thereon with a number of third pads, wherein a second portion of the redistribution layer serves as second interconnect lines that are electrically connected to the third pads, and wherein a top surface of a portion of the second interconnect line is exposed to form an external contact pad. With this arrangement, a redistribution process can be used to simultaneously fabricate the first and second interconnect lines, the external contact pads and other electrical structures necessary for the MCU chip, making the process simpler and reducing its cost. Moreover, the formation of solder joints is avoided, resulting in high reliability. Further, the redistribution process is helpful in layout optimization of the first, second and third pads and the external contact pads and can reduce wire crossovers within the package, or even completely eliminate the risk of wire crossing in extreme cases.

Optionally, the redistribution layer may comprise one redistribution layer, wherein a first portion of the one redistribution layer serves as the first interconnect lines, and a second portion of the one redistribution layer serves as the second interconnect lines. With this arrangement, the single redistribution layer can provide the first and second interconnect lines and all the other necessary electrical structures, thus making the process simpler and reducing its cost. Moreover, the formation of solder joints is avoided, resulting in high reliability. Further, the resulting product exhibits better performance and has even smaller dimensions.

Optionally, the redistribution layer may comprise a first redistribution layer and a second redistribution layer, which are formed one above the other over the fan-out surface from bottom upwards, wherein a first portion of the first redistribution layer serves as the first interconnect lines, and a second portion of the first redistribution layer and a portion of the second redistribution layer serve as the second interconnect lines that are electrically connected to the third pads. This redistribution process is helpful in layout optimization of the first, second and third pads and can reduce wire crossovers within the package, or even completely eliminate the risk of wire crossing in extreme cases. Moreover, the interconnects that connect the pads are all redistribution wires formed by the advanced packaging technique, but not bonding wires formed using an ordinary packaging technique. Accordingly, the formation of solder joints is avoided, resulting in high reliability and time savings. Optionally, solder balls may be formed on the external contact pads. This dispenses with the need to arrange a packaging substrate at the bottom after the fan-out surface is formed. Instead, the redistribution layer is directly formed on the fan-out surface by the advanced packaging technique, and then the solder balls are formed on the external contact pads. The resulting package has a comparable shape to a BGA/WLCSP chip package and smaller dimensions and exhibits better performance.

Optionally, conductive pads may be formed on top surfaces of the external contact pads, wherein the conductive pads are distributed along the periphery of the package, and a top or side surface of each conductive pad is exposed outside the package. This dispenses with the need to arrange a lead frame after the fan-out surface is formed. Instead, the redistribution layer is directly formed on the fan-out surface by the advanced packaging technique, and then the conductive pads are formed on the external contact pads. The resulting package has a comparable shape to a QFN chip package and smaller dimensions and exhibits better performance, for example, in terms of thermal simulation.

Optionally, an area of each of the first and second pads is smaller than an area of the third pad. This can reduce the area of the first and second pads as much as possible, thereby avoiding, to the most possible extent, additional chip area expansions.

Optionally, the area and a dimension of each of the first and second pads meets a minimum specification allowed by a connection process of the first interconnect line. As the area of the first pad and the second pad is minimized to the smallest possible size in the manufacturing process, thereby avoiding, to the most possible extent, additional chip area expansions.

Optionally, the package may further comprise a semiconductor substrate, wherein both the MCU die and the Flash die are mounted in a trench in the semiconductor substrate, and the top surfaces of the MCU die, the Flash die and the semiconductor substrate together provide the fan-out surface, wherein the MCU die and the Flash die is bonded to the bottom of the single trench or different trenches by a bonding layer, and wherein gaps left from the mounting of the MCU die and the Flash die in the trench are filled with a dielectric material.

As long as the number of first pads on the MCU die allows, various numbers of Flash dies of various capacities and with various numbers of second pads may be incorporated. This enables more flexible MCU design and efficient MCU development completed within a short term. Optionally, two Flash dies may be included, one of which is used to support online operation of the MCU chip, and the other is used to support upgrading of the MCU chip.

Optionally, a number of the first interconnect lines serving as the multi-bit address lines is (A+1), wherein a corresponding maximum physically addressable space in the memory array is [0, 2A+1-1].

Optionally, the first interconnect lines that serve as the multi-bit memory control signal lines may be configured to transmit control signals generated by the memory control logic circuit based on corresponding read, write and erase commands, and a number of the first interconnect lines serving as the multi-bit data lines is (D+1), corresponding to a bit width of the memory array for data read and write.

### BRIEF DESCRIPTION OF THE DRAWINGS

Those of ordinary skill in the art will understand that the following drawings are presented to enable a better understanding of the present invention and not intended to limit the scope thereof in any sense, in which:
Fig. 1 schematically illustrates the system architecture of a microcontroller unit (MCU) chip incorporating SiP flash memory;
Fig. 2 schematically illustrates the system architecture of an MCU chip according to a first embodiment of the present invention;
Fig. 3 is a schematic cross-sectional view of an exemplary structure resulting from a fan-out packaging process performed on an MCU die according to the first embodiment of the present invention;
Fig. 4 is a schematic cross-sectional view of a structure resulting from a QFN packaging process performed on the MCU die of Fig. 3;
Fig. 5 is a schematic top view of a structure resulting from a QFN packaging process performed on the MCU die of Fig. 3;
Fig. 6 is a schematic cross-sectional view of a structure resulting from a BGA/WLCSP packaging process performed on the MCU die of Fig. 3;
Fig. 7 is a schematic top view of a structure resulting from a BGA/WLCSP packaging process performed on the MCU die of Fig. 3;
Fig. 8 is a schematic diagram of another exemplary structure resulting from a BGA/WLCSP packaging process performed on the MCU die according to the first embodiment of the present invention;
Figs. 9 to 11 are schematic cross-sectional views of structures resulting from other advanced packaging processes performed on the MCU die according to the first embodiment of the present invention;
Fig. 12 is a schematic timing diagram of data transmission between the MCU die and a Flash die in the MCU chip according to the first embodiment of the present invention;
Fig. 13 schematically illustrates the system architecture of an MCU chip according to a second embodiment of the present invention; and
Fig. 14 is a schematic top view of the MCU chip of Fig. 13.

### List of Reference Numerals

100-MCU chip; 101-MCU die; 101b-bus; 101c-random-access memory; 102-Flash die; 200-semiconductor substrate; 200a-trench; 201-MCU die; 101a, 201a-memory control logic circuit; 2011-first pad; 2012, 2012A, 2022-third pad; 202, 202a, 202b-Flash die; 2021-second pad; 203-first interconnect line; 204, 2041-second interconnect line; 204a- external contact pads; 205-bonding layer; 206-dielectric material; 207-first dielectric layer; 208-solder paste; 209-conductive pad; 210-second dielectric layer; 211-solder ball; DATA, DATAₐ, DATA_{b}-data line; RWCTL, RWCTLₐ, RWCTL_{b}-memory control signal line; ADDR, ADDRₐ, ADDR_{b}-address line.

### DETAILED DESCRIPTION

The following description sets forth numerous specific details in order to provide a more thorough understanding of the present invention. However, it will be apparent to those skilled in the art that the present invention can be practiced without one or more of these specific details. In other instances, well-known technical features have not been described in order to avoid unnecessary obscuring of the invention. It is understood that the invention may be embodied in many different forms and should not be construed as being limited to the embodiments set forth below. Rather, these embodiments are provided so that this disclosure is thorough and conveys the scope of the invention to those skilled in the art. In the drawings, same reference numerals refer to same elements throughout. It will be understood that when an element is referred to as being "connected to" or "coupled to" another element, it can be directly connected or coupled to the other element, or intervening elements may also be present. In contrast, when an element is referred to as being "directly connected to" another element, there are no intervening elements. As used herein, the singular forms "a", "an" and "the" are intended to include the plural forms as well, unless the context clearly indicates otherwise. It will be further understood that the term "comprising" specifies the presence of stated features, steps, operations, elements, and/or components, but do not preclude the presence or addition of one or more other features, steps, operations, elements, components, and/or groups thereof. As used herein, the term "and/or" includes any and all combinations of the associated listed items.

The present invention will be described in greater detail below with reference to the accompanying drawings, which illustrate specific embodiments thereof. From the following description, advantages and features of the present invention will become more apparent. Note that the figures are provided in a very simplified form not necessarily drawn to exact scale for the only purpose of helping to explain the disclosed embodiments in a more convenient and clearer way.

### Embodiment 1

Referring to Figs. 2 to 7, in Embodiment 1 of the present invention, there is provided a microcontroller unit (MCU) chip including an MCU die 201, a Flash die 202 and a number of first interconnect lines 203, which are packaged within a single package using an advanced packaging technique.

The MCU die 201 and the Flash die 202 are standalone dies, which may be separately fabricated using different integrated circuit processes. At a given circuit area, the cost of fabricating a flash memory circuit is usually 30% higher than the cost of a standard circuit fabricated using the same process. Accordingly, in one implementation, the process for fabricating the Flash die 202 may have a larger critical dimension (CD) than that for the MCU die 201 in order to result in cost reductions.

The MCU die 201 may incorporate a memory control logic circuit 201a and logic circuits of other functions. In this embodiment, in addition to third pads 2012 also necessary for conventional MCU dies 201 (e.g., including input/output (I/O) pads providing an I/O interface for the MCU chip, a clock pad for transmission of a clock signal for the MCU chip and a power pad which is connected to an external power supply to provide the MCU chip with a power supply voltage), the MCU die 201 additionally includes a number of first pads 2011.

The Flash die 202 may incorporate a memory array (not shown), and read, write and erase operations may be performed on the memory array under the control of the memory control logic circuit 201a. The memory array may be used to store code necessary for upgrading and operation of the MCU chip and data generated during use of the MCU chip. The Flash die 202 additionally includes a number of second pads 2021, which correspond to all or some of the first pads 2011 on the MCU die 201.

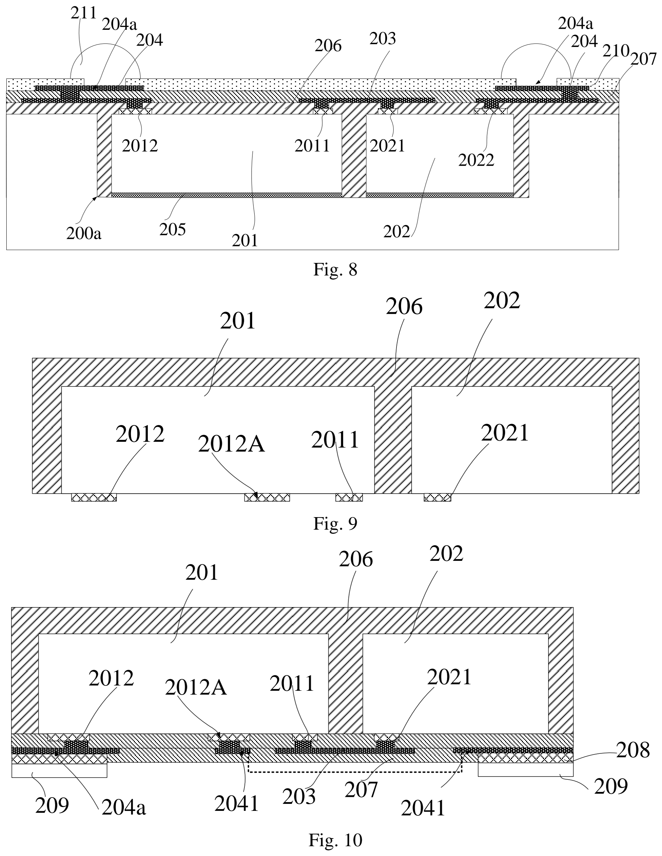

In some examples of this embodiment, referring to Fig. 8, in addition to the second pads 2021, the Flash die 202 may further include third pads 2022 for external connection. In further examples, the third pads 2022 on the Flash die 202 may be connected to an external power supply, ground or the like, allowing the Flash die 202 to be powered by the external power supply or externally grounded. In still further examples, if required, the Flash die 202 may be provided as SIP flash memory, and third pads 2022 may be included to provide a general-purpose interface for the flash memory. In yet still some other examples, referring to Figs. 3 to 7, the Flash die 202 may be powered by the MCU die 201, and such third pads 2022 for external connection may be omitted from the Flash die 202.

In this embodiment, the first interconnect lines 203 connect the first pads 2011 on the MCU die 201 to the respective second pads 2021 on the Flash die 202, forming address lines ADDR[A:0] of (A+1) bits, data lines DATA[D:0] of (D+1) bits and memory control signal lines RWCTL[x:0] of (x+1) bits, where A, D and x are all integers greater than 1.

It will be understood that the system architecture of the MCU chip of this embodiment is actually made up of the MCU die and the single Flash die arranged outside and connected to the MCU die. Therefore, the number of additional first pads 2011 on the MCU die 201 may be greater than or equal to the number of additional second pads 2021 on the Flash die 202. In customized applications, the number of additional first pads 2011 on the MCU die 201 may be equal to the number of additional second pads 2021 on the Flash die 202 in the MCU chip. In contrast, in more general applications, the number of additional first pads 2011 on the MCU die 201 tends to be greater than the number of additional second pads 2021 on the Flash die 202. In particular, the MCU die 201 may include a maximum permissible number of additional first pads 2011, and in this case, multiple Flash dies 202 of various specifications may be used, each having different capacity and including a number of second pads 2021, which is smaller than or equal to the maximum permissible number. This enables more flexible MCU design and efficient MCU development completed within a short term.

Notably, for a conventional MCU chip employing eFlash memory, when it is required to modify the flash memory circuit (e.g., to change its capacity), tape-out of various MCU die versions would be necessary for the manufacturer. Usually, such versions would all reserve an area corresponding to maximum capacity required by the eFlash memory circuit in order to avoid altering the layout and/or wiring of the rest of the standard MCU circuit, leading to a waste of chip area. On the contrary, according to the present invention, when it is required to modify the flash memory capacity of the MCU chip of this embodiment, the Flash die 202 can be simply replaced, without subjecting the MCU die 201 to additional tape-out. This can reduce the time required for the development of the MCU chip and circumvent the need for reserving an area required by maximum eFlash memory capacity, allowing the MCU chip to have a reduced overall area.

It will also be understood that, in this embodiment, the MCU die 201 and the Flash die 202 may be packaged within a single package using any suitable advanced packaging technique capable of forming the first interconnect lines 203.

In one example, referring to Figs. 3 to 5, the MCU die 201 and the Flash die 202 are packaged within a single package using a fan-out wafer-level packaging (FO-WLP) and a quad flat no-leads (QFN) packaging process.

For example, the FO-WLP process may include:
first providing a semiconductor substrate 200, which may be any suitable semiconductor material known in the art, such as silicon or a compound semiconductor material;
then forming trench 200a in the semiconductor substrate 200 using photolithography and etching processes;
subsequently, placing the MCU die 201 and the Flash die 202 side by side in the trench 200a with their front sides both facing upwards (i.e., the side of the MCU die 201 where the first pads 2011 are formed on and the side of the Flash die 202 where the second pads 2021 are formed on face upwards) and forming a bonding layer 205 of any suitable chip-bonding material, which bonds the MCU die 201 and the Flash die 202 at the bottom to a bottom surface of the trench 200a; and
afterwards, filling a dielectric material 206 in a gap between the MCU die 201 and the Flash die 202, gaps between the MCU die 201 and side walls of the trench 200a and gaps between the Flash die 202 and side walls of the trench 200a. Depending on the properties of the dielectric material 206, any suitable process may be employed to fill it in the gaps. For example, the dielectric material 206 may be photoresist or another organic polymer dielectric material. In this case, it may be filled in the gaps using a coating process. As another example, the dielectric material 206 may be an inorganic dielectric material such as silicon oxide, which may be filled in the gaps by vapor deposition.

As a result, an intermediate package is obtained, which includes the semiconductor substrate 200, the MCU die 201, the Flash die 202, the bonding layer 205 and the dielectric material 206. Top surfaces of the MCU die 201, the Flash die 202 and the semiconductor substrate 200 provide a fan-out surface of the intermediate package. In addition to filling the aforementioned gaps, the dielectric material 206 may be also present on the fan-out surface at a given thickness.

After that, the QFN packaging process is carried out on the intermediate package resulting from the FO-WLP process. For example, the QFN packaging process may include:
first performing appropriate processes, such as photolithography and etching, to form openings in the dielectric material 206, which expose surfaces of the first pads 2011 on the MCU die 201 and the second pads 2021 on the Flash die 202.

Next, a redistribution layer (RDL) is formed on a top surface of the dielectric material 206 using a redistribution process. The RDL layer includes a first RDL layer and a first dielectric layer 207, which are sequentially formed over the top surface of the dielectric material 206. A portion of the second interconnect line 204 exposed out of the first dielectric layer 207 serves as an external contact pad 204a. Additionally, a portion of the first RDL layer serves as the first interconnect lines 203 that connect the first pads 2011 and the second pads 2021 and thereby form the (A+1)-bit address lines ADDR[A:0], the (D+1)-bit data lines DATA[D:0] and the (x+1)-bit memory control signal lines RWCTL[x:0]. In one example, the redistribution process includes: depositing a metal material on a surface of the semiconductor substrate 200; forming redistribution (metal) wires using, for example, photolithography and etching processes; depositing the dielectric material; and forming new openings (corresponding to the external contact pads) by photolithography and etching. The redistribution wires and the pads are electrically connected to allow redistribution of I/O ports for associated signals.

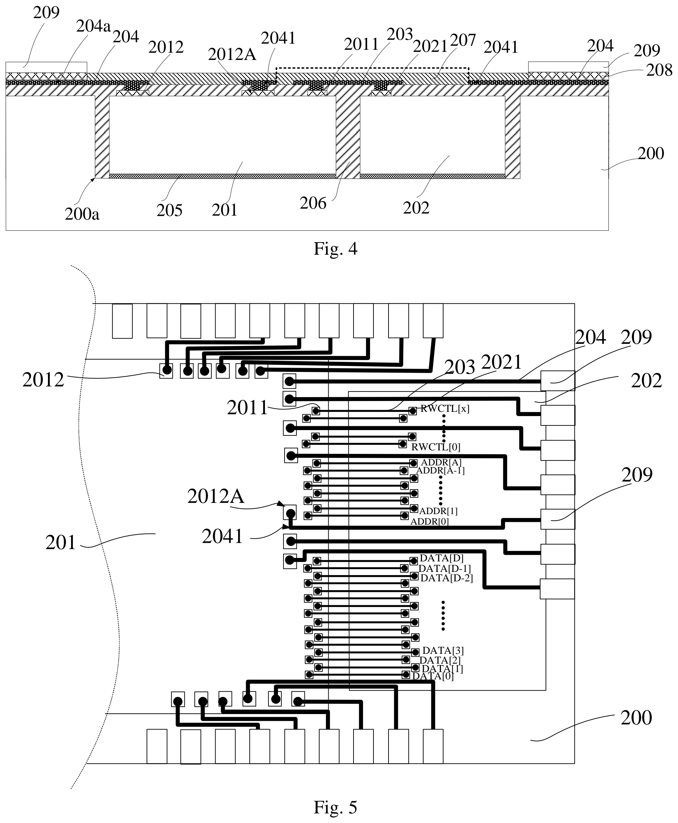

After that, with combined reference to Figs. 4 and 5, a solder paste 208 based on, for example, Ni, Au or a Ni-Au alloy, is dispensed onto each of the external contact pads 204a, and conductive pads 209 are attached to the external contact pads 204a by the solder paste 208. The conductive pads 209 are distributed along the periphery of the semiconductor substrate 200, and their top and side surfaces are all exposed out of the first dielectric layer 207. Adjacent conductive pads 209 are spaced apart. In this way, a similar shape to that of a conventional QFN package is obtained. Compared with conventional QFN packaging, the use of a lead frame is dispensed with, and a compacter product size and improved performance, for example, in terms of thermal simulation are obtained.

Notably, in this embodiment, the first pads 2011 are arranged along a first side of the MCU die 201 proximal to the Flash die 202, and the second pads 2021 are arranged along a second side of the Flash die 202 proximal to the MCU die 201. Thus, the first pads 2011 and the second pads 2021 are arranged in proximity to each other. This makes the first interconnect lines 203 easy to design and allows them to have a shorter length and run in parallel, thereby eliminating the risk of wire crossing and enabling more reliable line, faster signal transmission.

Further, in this embodiment, the third pads 2012 on the MCU die 201 are of the same size (area and dimensions) as conventional pads, and the first pads 2011 are of the same size as the second pads 2021, which may be smaller than the size of the third pads 2012. That is, the first pads 2011 and the second pads 2021 may have a smaller area and smaller dimensions than the third pads 2012. For example, the area and dimension of the first pad 2011 and the second pad 2021 are minimized to the smallest extent allowed by the manufacturing process, as long as meeting the minimum specification for the stability and reliability of the connection process of the first interconnect line 203, avoiding leading to any area expansion of the semiconductor substrate 200. In one implementation, the first pads 2011 and the second pads 2021 are at least partially made of metal aluminum or an aluminum-copper alloy, in order to facilitate their connection with the first interconnect lines 203 (e.g., copper).

As noted above, a portion of the first RDL layer serves as the first interconnect lines 203 that connect the first pads 2011 and the second pads 2021 and thereby form the (A+1)-bit address lines ADDR[A:0], the (D+1)-bit data lines DATA[D:0] and the (x+1)-bit memory control signal lines RWCTL[x:0]. The remaining of the first RDL layer serves as the aforementioned second interconnect lines 204 that are electrically connected to the third pads 2012. The first dielectric layer 207 serves as a passivation layer, and the first interconnect lines 203 and a portion of each second interconnect line 204 are embedded therein. In addition, a portion of the second interconnect line 204 exposed out of the first dielectric layer 207 serves as the external contact pad 204a.

In this embodiment, since the first and second interconnect lines are formed using a redistribution process, the layout of the external contact pads 204a, the first pads 2011, the second pads 2021 and other structures may be optimized to reduce or even eliminate the risk of wire crossing.

Further, compared with conventional QFN packaging, the QFN packaging process described herein dispenses with the use of a lead frame and can directly produce a square package comparable to those produced by conventional QFN packaging. Additionally, the resulting product has even smaller dimensions and exhibits better performance in terms of, for example, thermal simulation.

In another example, referring to Figs. 3, 6 and 7, the MCU die 201 and the Flash die 202 are packaged within a single package using an FO-WLP process and a ball grid array (BGA) or wafer level chip scale packaging (WL-CSP) process.

The FO-WLP process may be the same as has been described above and, therefore, needs not be described in further detail here. An intermediate package resulting from the FO-WLP process includes a semiconductor substrate 200, the MCU die 201, the Flash die 202, a bonding layer 205 and a dielectric material 206. A trench 200a is formed in the semiconductor substrate 200, and the MCU die 201 and the Flash die 202 are both oriented with their front sides facing upwards (i.e., the side of the MCU die 201 where the first pads 2011 are formed on and the side of the Flash die 202 where the second pads 2021 are formed on face upwards) and placed side by side in the trench 200a. The MCU die 201 and the Flash die 202 are bonded at the bottom to a bottom surface of the trench 200a by the bonding layer 205. The dielectric material 206 fills a gap between the MCU die 201 and the Flash die 202, gaps between the MCU die 201 and side walls of the trench 200a and gaps between the Flash die 202 and side walls of the trench 200a. Top surfaces of the MCU die 201, the Flash die 202 and the semiconductor substrate 200 provide a fan-out surface. In addition to filling the gaps, the dielectric material 206 may also be present on the fan-out surface at a given thickness.

The BGA packaging process may be then performed on the intermediate package resulting from the FO-WLP process. For example, it may include:
first performing appropriate processes, such as photolithography and etching, to form openings in the dielectric material 206, which expose surfaces of the first pads 2011 on the MCU die 201 and the second pads 2021 on the Flash die 202.

Next, an RDL layer is formed on a top surface of the dielectric material 206 using a redistribution process. The RDL layer includes a first RDL layer, a first dielectric layer 207, a second RDL layer and a second dielectric layer 210, which are sequentially formed over the top surface of the dielectric material 206. A portion of the first RDL layer serves as the first interconnect lines 203 that connect the first pads 2011 and the second pads 2021 and thereby form the (A+1)-bit address lines ADDR[A:0], the (D+1)-bit data lines DATA[D:0] and the (x+1)-bit memory control signal lines RWCTL[x:0]. A portion of the second RDL layer is electrically connected at one end to the remaining of the first RDL layer and hence to the third pads 2012 on the MCU die 201. The other end of the second RDL layer serves for external connection of the third pads 2012 on the MCU die 201. That is, a portion of the first RDL layer serves as the first interconnect lines 203, and the remaining of the first RDL layer and a portion of the second RDL layer together serve as the second interconnect lines 204 that are electrically connected to the third pads 2012 and further connect the third pads 2012 to the outside world. The second dielectric layer 210 serves as a passivation layer, and the second interconnect lines 204 are partially embedded therein. Moreover, the remaining portion of each second interconnect line 204 exposed out of the second dielectric layer 210 serves as an external contact pad 204a. The first and second RDL layers may be made of the same material, such as, for example, copper (Cu).

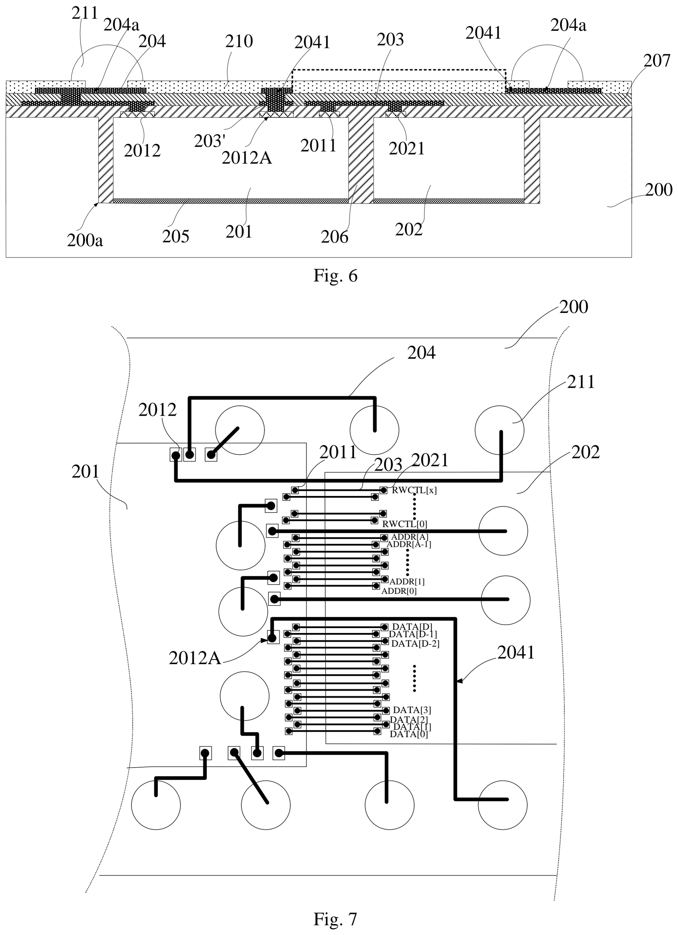

Subsequently, with combined reference to Figs. 6 and 7, solder balls or columns (also called conductive bumps) 211 are formed on the respective external contact pads 204a. The solder balls 211 may be made of Ni, Au, a Ni-Au alloy or the like.

Compared with conventional BGA packaging, the BGA packaging process described herein dispenses with the use of an additional substrate and can directly produce a package in the same shape as those produced by conventional BGA packaging. Additionally, the resulting product has even smaller dimensions and exhibits better performance in terms of, for example, thermal simulation.

Notably, the third pads 2012 may be arranged on the MCU die 201 in any desired way. For example, they may be arranged along the periphery of the MCU die 201.

As an example, referring to Figs. 4 to 7, some of the third pads 2012 may be arranged in a peripheral region of the MCU die 201 along its first side proximal to the Flash die 202, and some 2012A of these third pads 2012 arranged along the first side of the MCU die 201 may be connected by respective ones of the second interconnect lines 2041 to conductive pads 209 (see Fig. 5) or solder balls 211 (see Fig. 7) around a first side of the Flash die 202 (which is opposite to the aforementioned second side and faces away from the MCU die 201). In order to reduce parasitic capacitance and other parasitic parameters, the second interconnect lines 2041 that connect the third pads 2012A may be staggered from the first interconnect lines 203.

It will be understood that, although the MCU die and the Flash die have been described in the above implementations as being bonded by a bonding layer to the bottom of a single trench formed in a semiconductor substrate, the present invention is not so limited, because in alternative implementations, as many trenches as the total number of MCU and Flash dies may be formed in the semiconductor substrate, each for a respective one of the dies. In these cases, during packaging, the MCU and Flash dies may be placed in the respective trenches. In further implementations of the present invention, the semiconductor substrate may be instead made of a plastic (compound) or other material.

It will also be understood that, in other examples of this embodiments, as shown in Figs. 9 to 11, the MCU die and the Flash die may be co-packaged using other advanced fan-out packaging techniques.

For example, Fig. 9 shows an intermediate package resulting from another FO-WLP process, in which both the MCU die 201 and the Flash die 202 are oriented with their top surfaces facing downwards (i.e., the side of the MCU die 201 where the first pads 2011 are formed on and the side of the Flash die 202 where the second pads 2021 are formed on face downwards) and encapsulated by the dielectric material 206 through injection molding. The top surfaces of the MCU die 201 and the Flash die 202 provide a fan-out surface. Compared with the process for forming the intermediate package of Fig. 3, the steps of providing the semiconductor substrate 200 and forming the trench 200a in the semiconductor substrate 200 by photolithography and etching are omitted from the process for forming the intermediate package of Fig. 9. Differing from the intermediate package of Fig. 3, in which the dielectric material 206 fills the gap between the MCU die 201 and the Flash die 202, the gaps between the MCU die 201 and the side walls of the trench 200a and the gaps between the Flash die 202 and the side walls of the trench 200a, is possibly present on the fan-out surface at a given thickness, and does not cover backsides of the MCU die 201 and the Flash die 202, and the bonding layer 205 is located between backsides of the MCU die 201 and the Flash die 202 and the bottom surface of the trench 200d, in the intermediate package of Fig. 9, the dielectric material 206 formed by injection molding instead of filling covers the backsides of the MCU die 201 and the Flash die 202, and surfaces of the MCU die 201 and the Flash die 202 are located at the fan-out surface (the front sides of the MCU die 201 and the Flash die 202) is flush with the fan-out surface, and the trench 200a and the bonding layer 205 shown in Fig.3a are omitted.

As can be seen, in both the intermediate packages of Figs. 3 and 9, the top surfaces of the MCU die 201 and the Flash die 202 together provide a fan-out surface.

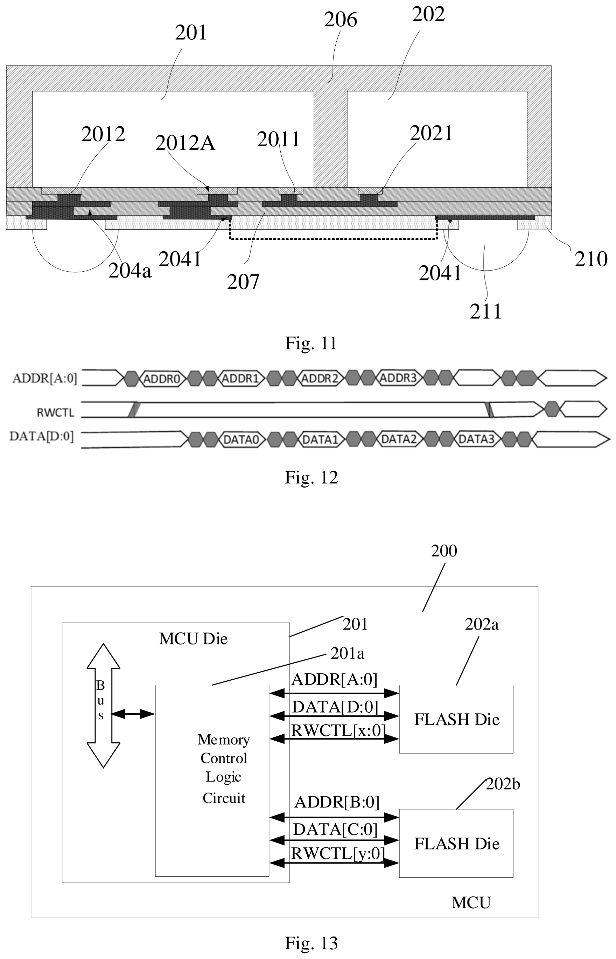

Figs. 10 and 11 show packages obtained by further performing QFN (Fig. 10) and BGA (Fig. 11) packaging processes on the intermediate package of Fig. 9, respectively. The packages of Figs. 10 and 11 correspond to those of Figs. 4 and 6 and, therefore, need not be described in further detail here. Notably, the advanced packaging techniques employed in the above examples are merely illustrative and exemplary and are in no way intended to limit the present embodiment to any of those advanced packaging techniques. Additionally, instead of one or more RDL layers, more RDL layers are possible depending on the wiring requirements.

It will be understood that, regardless of the advanced packaging techniques used in this embodiment to package the MCU die 201 and the Flash die 202 together, it is necessary to connect the first pads 2011 on the MCU die 201 and the second pads 2021 on the Flash die 202 with the first interconnect lines 203 to form the multi-bit address lines ADDR[A:0], the multi-bit data lines DATA[D:0] and the multi-bit memory control signal lines RWCTL[x:0].

Fig. 12 shows a schematic timing diagram of data transmission between the MCU die 201 and the Flash die 202. As shown, multiple bits of ADDR, DATA and RWCTL are transmitted in parallel. Different values of RWCTL correspond to respective modes of operation. Thus, read, write and erase operations can be performed on the Flash die 202 by changing values of ADDR, DATA and RWCTL. For example, when a read access request is received over a bus in the MCU die 201, a data read mode may be initiated by setting RWCTL to an associated value, and the requested code and/or data may be then read in parallel according to addresses and data indicated in the read access request from the Flash die 202 via the multi-bit address lines ADDR[A:0] and the multi-bit data lines DATA[D:0]. When a write access request is received over the bus in the MCU die 201, a data write mode may be initiated by setting RWCTL to a different associated value, and the intended code and/or data may be then written in parallel according to addresses and data indicated in the write access request to the Flash die 202 via the multi-bit address lines ADDR[A:0] and the multi-bit data lines DATA[D:0].

In one implementation, the number of the first interconnect line lines 203, serving as the multi-bit address lines ADDR[A:O], is (A+1), and a corresponding maximum physically addressable space in the memory array of the Flash die 202 may be [0, 2^{A+1-} 1]. For example, if A+1=32, then the corresponding maximum physically addressable space in the flash memory for the 32-bit address lines ADDR[31:0] may be 0xFFFFFFFF - 0x00000000.

In another implementation, first interconnect lines 203 in the multi-bit memory control signal lines RWCTL are used to transmit control signals generated by the memory control logic circuit 201a based on read, write and erase commands. In some other implementations, the number of the first interconnect lines serving as the multi-bit data lines DATA[D:O] is (D+1), corresponding to a bit width, at which data is read and written from and to the memory array in the Flash die 202.

Notably, the memory control logic circuit 201a of this embodiment is implemented by a circuit, which is totally different from circuits of conventional memory control logic circuits 101a. For example, in the conventional circuit of Fig. 1, the communication between the FLASH die 102 and the MCU die 101 is conducted through the SPI serial protocol. Accordingly, the memory control logic circuit 101a needs to carry out parallel-to-serial protocol conversion to generate I/O (DATA IO), clock (CLK) and chip select (CS) signals as required by the SPI protocol and requires additional buffers or latches for enabling such protocol conversion. In contrast, in this embodiment, as shown in Fig. 2, the Flash die 202 and the MCU die 201 may communicate according to a custom, dedicated parallel protocol, and the memory control logic circuit 201a may be directly coupled between the bus in the MCU die 201 (i.e., the bus of Fig. 2 may be an internal high-speed bus, such as AXI or AHB) and the first interconnect lines 203 to control data transmission between the MCU die 201 and the Flash die 202 by transforming control signals from the internal high-speed bus into flash memory interface signals (i.e., address signals, data signals, and read, write and erase control signals). The memory control logic circuit 201a may allow the MCU die 201 to directly store program code in the Flash die 202 and to directly access such program code, without copying data from the Flash die 202 to random-access memory (RAM) (typically static RAM (SRAM)). Omitting the RAM can result in area and cost savings. Further, the flash memory interface signals can be transmitted in parallel without parallel-to-serial protocol conversion, additionally reducing the circuit area of the MCU die 201.

In this embodiment, since address signals, data signals and read, write and erase control signals are directly transmitted in parallel in a peer-to-peer manner without protocol conversion between the MCU die 201 and the external Flash die 202, the MCU die 201 can read, write and erase data in the Flash die 202 at greatly increased speeds as if it performed data read and write operations on eFlash memory. In addition, as the MCU die 201 and the Flash die 202 are standalone dies, the eFlash memory does not undesirably occupy any area of the MCU die 201.

In summary, this embodiment provides advantages including high capacity, inexpensive memory and a short time to market, and is not faced with many challenges in terms of fabrication. It can be used in 22-nm or smaller nodes of silicon photolithography technology and enables development of MCU chips to more advanced processes.

### Embodiment 2

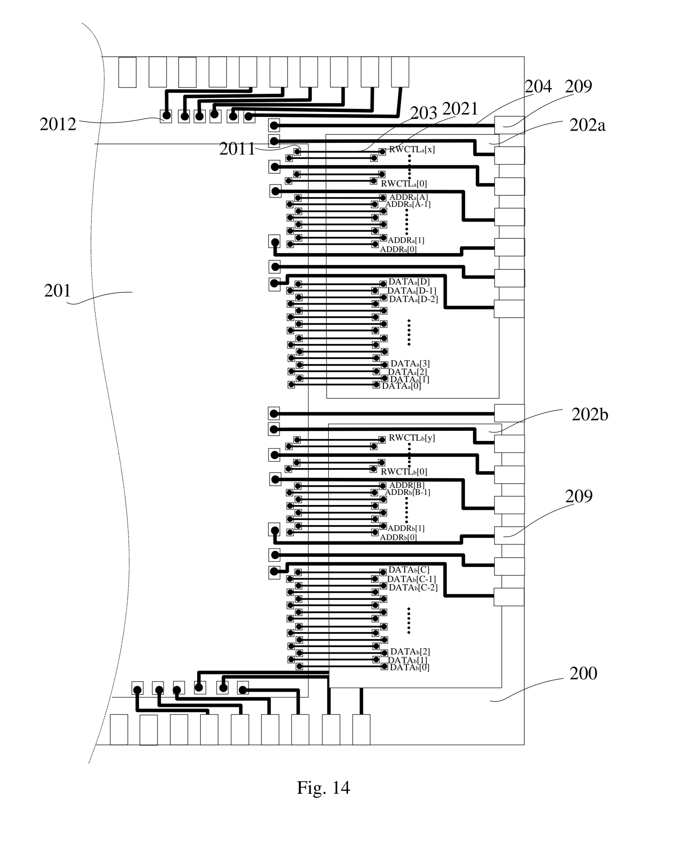

Referring to Figs. 13 to 14, in Embodiment 2 of the present invention, there is provided an MCU chip including an MCU die 201, two Flash dies 202a, 202b and a number of first interconnect lines 203, which are packaged within a single package using an advanced packaging technique.

The MCU die 201 and the Flash dies 202a, 202b are standalone dies, which may be separately fabricated using different integrated circuit processes. In alternative implementations, the two Flash dies 202a, 202b may be fabricated using a single integrated circuit process.

The MCU die 201 may incorporate a memory control logic circuit 201a and logic circuits of other functions and be provided on its top surface with a number of additional first pads. Moreover, each of the Flash dies 202a, 202b may be provided with a number of additional second pads, which correspond to all or some of the first pads 2011 on the MCU die 201. Specifically, some first pads 2011 on the MCU die 201 are connected to the respective second pads 2021 on the Flash die 202a through respective ones of the first interconnect lines, thereby forming address lines ADDRₐ[A:0] of (A+1) bits, data lines DATAₐ[D:0] of (D+1) bits and memory control signal lines RWCTLₐ[x:0] of (x+1) bits. Other ones of the first pads 2011 on the MCU die 201 are connected to the respective second pads 2021 on the Flash die 202b through other respective ones of the first interconnect lines, forming address lines ADDR_{d}[B:0] of (B+1) bits, data lines DATA_{b}[C:0] of (C+1) bits and memory control signal lines RWCTL_{b}[y:0] of (y+1) bits, where A, B, C, D, x and y are all integers greater than 1.

One of the Flash dies 202a, 202b is used to support online operation of the MCU chip 201, and the other is used to support upgrading of the MCU chip 201. That is, the Flash dies 202a, 202b separately incorporate respective memory arrays. One of the Flash dies 202a, 202b is used to store code necessary for upgrading of the MCU chip, and the other is used to store code necessary for operation of the MCU chip, and data generated during operation of the MCU chip.

Reference is made to the above description in connection with Figs. 3 to 8 for more structural details of the MCU die 201 and the two Flash dies 202a, 202b, and they may be packaged within a single package using the same advanced packaging techniques as in the first embodiment and, therefore, need not be described in further detail here.

It will be understood that the system architecture of the MCU chip of this embodiment is actually made up of the MCU die and the two Flash dies both arranged outside and connected to the MCU die. Therefore, the number of additional first pads 2011 on the MCU die 201 may be greater than or equal to the total number of additional second pads 2021 on the Flash dies 202a, 202b.

Compared with the MCU chip of the first embodiment, the MCU chip of this embodiment includes two Flash dies, each of which carries out multi-bit parallel communication with a respective set of first pads 2011 on the MCU die without protocol conversion. Therefore, a mode of operation with multiple Flash dies is supported.

It will be understood that the present invention is not limited to being used in applications with externally connected Flash die(s) 202. Instead, in MCU chip architectures according to the present invention, for example, SRAM, sensors, power management units (PMUs) and radio-frequency (RF) circuits may also be packaged with MCU dies within single packages using advanced packaging techniques. Specifically, the Flash die(s) 202 in the embodiment of Fig. 2 or 13 may be each replaced with a SRAM die, sensor die, PMU die or RF circuit die.

The description presented above is merely that of some preferred embodiments of the present invention and does not limit the scope thereof in any sense. Any and all changes and modifications made by those of ordinary skill in the art based on the above teachings fall within the scope as defined in the appended claims.

## Claims

1. A microcontroller unit (MCU) chip, comprising:
an MCU die, wherein the MCU die incorporates an internal memory control logic circuit and is provided with a number of external first pads on a first side;
at least one Flash die, wherein the Flash die incorporates an internal memory array and is provided with a number of external second pads on a second side; and
a number of first interconnect lines connecting the second pads to corresponding first pads, thereby forming multi-bit address lines, multi-bit data lines and multi-bit memory control signal lines, and
wherein the MCU die, the at least one Flash die and the number of first interconnect lines are packaged within a single package using an advanced packaging technique.

2. The MCU chip of claim 1, wherein the MCU die and the Flash die are arranged side by side, wherein the first pads are arranged on the first side of the MCU die proximal to the Flash die, and wherein the second pads are arranged on the second side of the Flash die proximal to the MCU die.

3. The MCU chip of claim 1, wherein top surfaces of the MCU die and the Flash die provide a fan-out surface of an intermediate package of a package.

4. The MCU chip of claim 3, wherein the package further comprises an internal redistribution layer formed on the fan-out surface, wherein a first portion of the redistribution layer serves as the first interconnect lines.

5. The MCU chip of claim 4, wherein at least one of the MCU die and the Flash die is further provided thereon with a number of third pads, wherein a second portion of the redistribution layer serves as second interconnect lines that are electrically connected to the third pads, and wherein a top surface of a portion of the second interconnect line is exposed to form an external contact pad.

6. The MCU chip of claim 5, wherein the redistribution layer comprises one redistribution layer, wherein a first portion of the one redistribution layer serves as the first interconnect lines, and a second portion of the one redistribution layer serves as the second interconnect lines.

7. The MCU chip of claim 5, wherein the redistribution layer comprises a first redistribution layer and a second redistribution layer, which are formed one above the other over the fan-out surface from bottom upwards, wherein a first portion of the first redistribution layer serves as the first interconnect lines, and a second portion of the first redistribution layer and a portion of the second redistribution layer serve as the second interconnect lines that are electrically connected to the third pads.

8. The MCU chip of claim 5, wherein solder balls are formed on the external contact pads.

9. The MCU chip of claim 5, wherein conductive pads are formed on top surfaces of the external contact pads, wherein the conductive pads are distributed along a periphery of the package, and wherein a top or side surface of each conductive pad is exposed outside the package.

10. The MCU chip of claim 5, wherein an area of each of the first and second pads is smaller than an area of the third pad.

11. The MCU chip of any one of claims 1 to 10, wherein the area and a dimension of each of the first and second pads meets a minimum specification allowed by a connection process of the first interconnect line.

12. The MCU chip of claim 3, wherein the package further comprises a semiconductor substrate, wherein each of the MCU die and the Flash die is mounted in a trench in the semiconductor substrate, wherein the top surfaces of the MCU die, the Flash die and the semiconductor substrate provide the fan-out surface, wherein the MCU die and the Flash die is bonded to a bottom of a single trench or to bottoms of different trenches by a bonding layer, and wherein gaps left from mounting of the MCU die and the Flash die in the trench are filled with a dielectric material.

13. The MCU chip of claim 1, comprising two Flash dies, wherein one of the two Flash dies is used to support online operation of the MCU chip, and the other Flash dies is used to support upgrading of the MCU chip.

14. The MCU chip of any one of claims 1 to 10 or 12 to 13, wherein a number of the first interconnect lines serving as the multi-bit address lines is (A+1), and wherein a corresponding maximum physically addressable space in the memory array is [0, 2^{A+1}-1].

15. The MCU chip of any one of claims 1 to 10 or 12 to 13, wherein the first interconnect lines that serve as the multi-bit memory control signal lines are configured to transmit control signals generated by the memory control logic circuit based on corresponding read, write and erase commands, and wherein a number of the first interconnect lines serving as the multi-bit data lines is (D+1), corresponding to a bit width of the memory array for data read and write.
